(19) Europäisches Patentamt
European Patent Office
Office européen des brevets

(11) Veröffentlichungsnummer: **0 194 413**
**A2**

(12) # EUROPÄISCHE PATENTANMELDUNG

(21) Anmeldenummer: **86100444.8**

(22) Anmeldetag: **15.01.86**

(51) Int. Cl.4: **H 05 K 3/28**
C 08 G 73/10

(30) Priorität: **25.02.85 DE 3506526**

(43) Veröffentlichungstag der Anmeldung:
**17.09.86 Patentblatt 86/38**

(84) Benannte Vertragsstaaten:
**AT BE CH DE FR GB IT LI LU NL SE**

(71) Anmelder: **Akzo GmbH**
**Postfach 10 01 49 Kasinostrasse 19-23**
**D-5600 Wuppertal-1(DE)**

(72) Erfinder: **Kundinger, Ernst F., Dipl.-Chem.**
**Odenwaldring 28**
**D-6127 Breuberg/Neustadt(DE)**

(72) Erfinder: **Klimesch, Erich**
**Berliner Strasse 11**
**D-8765 Erlenbach(DE)**

(72) Erfinder: **Zengel, Hans G., Dr. Dipl.-Ing.**
**Nordring 6**
**D-8751 Kleinwallstadt(DE)**

(72) Erfinder: **Lasher, Jeffery D.**
**20 Alfred Drive**
**Tolland Connecticut 06084(US)**

(54) **Gedrucktes Schaltelement mit Polyimid enthaltender Deckschicht.**

(57) Die Erfindung betrifft ein gedrucktes Schaltelement, bei dem die äußeren Leiterbahnschichten bzw. die darauf angeordneten elektrischen Bauelemente mit einer Deckschicht versehen sind. Die Deckschicht besteht aus heißsiegelbarem Hochtemperaturklebstoff, der mit einer Schicht aus nicht mehr formbarem vollaromatischem Polyimid verbunden ist.

Die beschriebenen Schaltelemente besitzen sehr gute mechanische, thermische und elektrische Eigenschaften und können vorteilhaft u.a. in der Elektronik, Funk- und Computertechnik, in Elektromotoren sowie in der Luft- und Raumfahrt eingesetzt werden.

# Gedrucktes Schaltelement mit Polyimid enthaltender Deckschicht

A k z o GmbH
Wuppertal

-.-.-.-.-

Die Erfindung betrifft ein gedrucktes Schaltelement aus einer oder mehreren metallischen Leiterbahnschichten und damit fest verbundenen Isolierschichten, wobei auf einer oder auf beiden der äußeren Leiterbahnschichten bzw. den darauf angeordneten elektrischen Bauelementen eine Deckschicht angebracht ist. Gedruckte Schaltelemente finden u.a. in weiten Bereichen der Elektronik, der Funk- und Computertechnik, der Luft- und Raumfahrt und in Elektromotoren Anwendung. Zur elektrischen Isolierung gedruckter elektrischer Schaltkreise werden diese teilweise mit einer isolierenden Deckschicht versehen.

Diese elektrisch isolierende Deckschicht besteht üblicherweise aus einem Isolierlack, der auf die Schaltelemente aufgebracht ist.

Diese üblicherweise verwendeten Isolierlacke führen jedoch zu einer Reihe von Nachteilen der mit ihnen versehenen Schaltelemente:

a) die Isolierlacke sind thermisch nicht stabil genug, um die extremen Temperaturen, die beim Einsatz der gedruckten Schaltelemente auftreten können, ohne Beeinträchtigung zu überstehen. So kann es bei Temperatureinwirkung zu einer Formveränderung kommen, die sich in einer Verschlechterung der Isoliereigenschaften auswirkt

b) die Lacke erfüllen vielfach nicht die gestellten mechanischen Anforderungen, sie werden leicht angekratzt und können abblättern, was ebenfalls eine Verschlechterung der elektrischen Isolierwirkung nach sich zieht

c) die dielektrischen Eigenschaften der Lacke lassen zu wünschen übrig, sie besitzen vielfach keine ausreichende elektrische Durchschlagfestigkeit, das Frequenzverhalten der mit ihnen versehenen Schaltelemente kann beeinträchtigt sein, z.B. wegen Schwankungen der Dielektrizitätskonstante.

Aufgabe der vorliegenden Erfindung war es daher, ein gedrucktes Schaltelement gemäß Gattungsbegriff zur Verfügung zu stellen, das mit einer elektronisch hochwertigen, flexiblen und gegenüber extremen thermischen sowie mechanischen Bedingungen stabilen Deckschicht versehen ist.

Die Aufgabe wurde gelöst durch ein gedrucktes Schaltelement gemäß Gattungsbegriff, das dadurch gekennzeichnet ist,

daß die Deckschicht aus einem Schichtverbund aus einem nicht mehr formbaren, vollaromatischen, in phenolischen Lösungsmitteln unlöslichen Polyimid und einem direkt damit verbundenen heißsiegelbaren Hochtemperaturklebstoff besteht, wobei die nicht mit dem vollaromatischen Polyimid verbundene Oberfläche des Hochtemperaturklebstoffs mit der äußeren Leiterbahnschicht bzw. den darauf angeordneten elektrischen Bauelementen verbunden ist.

Unter einem gedruckten Schaltelement ist hierbei eine flächenhafte Schaltung auf isolierendem(n) Träger(n) zu verstehen, auf denen ein Leiterbild durch ein subtraktives oder additives Verfahren erzeugt worden ist. Beim subtraktiven Verfahren ist der Trägerwerkstoff (Isolierschicht) im Ausgangszustand auf einer oder beiden Seiten mit einer elektrisch leitenden Metallschicht bedeckt. Die Leiterkonfiguration wird als Schutzlackbedeckung durch Drucken oder durch einen Fotokopierprozeß auf die Metallschicht aufgebracht. Anschließend werden die unerwünschten freiliegenden Partien der Metallschicht weggeätzt und der Schutzlack beseitigt, so daß die Leiterkonfiguration in Form von Leiterbahnen übrig bleibt. Beim additiven Verfahren wird die Leiterkonfiguration als katalytische Schicht auf den isolierenden Träger aufgedruckt und anschließend auf dieser katalytischen Schicht eine Metallschicht abgeschieden. Auf den beim subtraktiven oder additiven Verfahren erhaltenen Leiterbahnen werden dann elektrische Bauelemente angebracht, im allgemeinen durch Löten.

Insbesondere auf den Leiterbahnen wird eine elektrisch isolierende Deckschicht aufgebracht. Aber auch auf der Bestückungsseite kann eine isolierende Deckschicht angebracht werden.

Diese isolierende Deckschicht muß auf den Leiterbahnen bzw. auf der Bestückungsseite gut haften und muß eine gute elektrische Isolierung darstellen. Daneben muß sie extreme thermische Belastungen überstehen.

Nicht mehr formbare, vollaromatische Polyimide besitzen ausgezeichnete Eigenschaften, was elektrische Isolierfähigkeit und thermische Beständigkeit anbelangt. Dies geht z.B. aus der DE-OS 22 27 953 hervor. Sie wären damit, was diese Eigenschaften anbelangt, als Deckschicht für gedruckte Schaltelemente geeignet. Es hat sich jedoch gezeigt, daß diese Polyimide nicht direkt mit den Leiterbahnen bzw. den darauf angeordneten elektrischen Bauelementen zu Schaltelementen verbunden werden können, bei denen die Haftung zwischen der Deckschicht aus Polyimid und dem Schaltelement ausreichend hoch ist, um starken mechanischen Beanspruchungen zu widerstehen. Dies liegt daran, daß diese Polyimide, die aus aromatischen Tetracarbonsäuren oder deren Dianhydriden und aromatischen Diaminen erhalten werden, nach ihrer Aushärtung weder formbar noch in herkömmlichen Lösungsmitteln löslich sind. Die Haftung zwischen Polyimid und Leiterbahn kann zwar dadurch erhöht werden, daß man die Polyimide oder deren Vorstufe vor der vollständigen Aushärtung auf das Schaltelement aufbringt. Da jedoch bei der Aushärtung flüchtige Bestandteile, u.a. Wasser, frei werden, kann die Freisetzung dieser Bestandteile durch das angebrachte Schaltelement gestört werden, und es kann zu Blasenbildung in der Polyimidschicht kommen.

Es wurde nun gefunden, daß ein gedrucktes Schaltelement mit einer hochwertigen Deckschicht erhalten wird, wenn die Deckschicht aus einem nicht mehr formbaren vollaromatischen, in phenolischen Lösungsmitteln unlöslichen Polyimid besteht, das mit einem heißsiegelbaren Hochtemperaturklebstoff direkt, d.h. ohne weitere Zwischenschicht verbunden ist. Die Deckschicht ist hierbei an der Seite des heißsiegelbaren Hochtemperaturklebstoffs mit den Leiterbahnen bzw. den darauf angeordneten elektrischen Bauelementen verbunden.

Unter "nicht mehr formbaren, vollaromatischen, in phenolischen Lösungsmitteln unlöslichen Polyimiden" werden hierbei Polyimide verstanden, die aus aromatischen Tetracarbonsäuren bzw. deren Dianhydriden und aus primären aromatischen Diaminen erhalten werden, wobei die Carboxyl- bzw. die primären Aminogruppen direkt an einen aromatischen Ring gebunden sind. Ferner sind die Polyimide nicht unzersetzt schmelzbar und in herkömmlichen Lösungsmitteln, also auch in phenolischen Lösungsmitteln wie Phenol, Kresolen und halogenierten Phenolen, unlöslich. Es ist also bei diesen Polyimiden weder über Schmelzen noch über Lösen eine neue Formgebung möglich.

Diese Polyimide können durch Umsetzung von Tetracarbonsäuren oder deren Mono- oder Dianhydriden mit Diaminen erhalten werden. Beispiele für geeignete Dianhydride sind Pyromellitsäuredianhydrid, 2,3,6,7-Naphthalintetracarbonsäuredianhydrid, 3,4, 3',4'-Diphenylsulfontetracarbonsäuredianhydrid, Perylen-3,4,9,10-tetracarbonsäuredianhydrid, 3,4, 3',4'-Diphenyläther-tetracarbonsäuredianhydrid.

Beispiele für Diamine, die mit den Tetracarbonsäuren bzw. deren Derivaten zu geeigneten nicht mehr formbaren, vollaromatischen Polyimiden umgesetzt werden können, sind: 4,4'-Diamino-diphenyläther; 5-Amino-2(p-Aminophenyl)-Benzothiazol; 4-Amino-2-(p-Aminophenyl)-Benzothiazol: 5-Amino-2-(m-Amino-phenyl)-Benzothiazol; 5-Amino-2-(p-Aminophenyl)-Benzoxazol; 4-Amino-2-(m-Aminophenyl)-Benzothiazol; p- und m-Phenylen-diamin; 4,4'-Diamino-Diphenyl; Bis-(4-Aminophenyl)-Methan; 4-Amino-2-(p-Aminophenyl)-Benzoxazol; 4-Amino-2-(m-aminophenyl)-benzoxazol; 5-Amino-2-(m-Aminophenyl)-Benzoxazol: 2,5-Diamino-Benzoxazol: 2,5-Diamino-Benzothiazol.

Als besonders geeignet hat sich das durch Umsetzung von Pyromellitsäuredianhydrid (PMDA) mit 4,4'-Diaminodiphenyläther (DADE) erhältliche Polyimid erwiesen.

Aus den genannten Verbindungen können nicht mehr formbare Polyimide über die Zwischenstufe der Polyamidsäure z.B. nach folgendem Verfahren erhalten werden, wobei zunächst eine Polyimidschicht auf einer Metallfolie, z.B. aus Kupfer, erzeugt wird:
Die Herstellung der Polyamidsäure erfolgt durch Umsetzung einer aromatischen Tetracarbonsäure, vorzugsweise Pyromellitsäure oder vorzugsweise ihres Dianhydrids, Pyromellitsäuredianhydrid (PMDA), mit einem primären aromatischen Diamin, bevorzugt ist 4,4'-Diaminodiphenyläther (DADE), in einem Lösungsmittel, zum Beispiel Dimethylacetamid (DMAc).
Zur mit Polyimid beschichteten Folie gelangt man durch Aufbringen eines Films der Polyamidsäurelösung auf eine Metallfolie und Aushärtung des Films in situ durch Hitzebehandlung

in mindestens zwei Stufen, so daß man ein sogenanntes single clad erhält, dessen Polyimidschicht an der Folie haftet.

Man setzt ein primäres aromatisches Diamin mit einer aromatischen Tetracarbonsäure oder ihrem Dianhydrid unter Bedingungen, die zur Bildung einer Lösung von Polyamidsäure in einem Lösungsmittel führen, um,z.B. in einem Extruder. Anschließend kann die Extrusion einer Schicht der Polyamidsäurelösung direkt auf die Folie erfolgen, wobei anschließend das Lösungsmittel in situ zunächst in einer ersten Heizzone weitgehend aus der Polyamidsäureschicht entfernt und die Polyamidsäureschicht dann in situ durch eine weitere Hitzebehandlung in mindestens einer zweiten Heizzone bei einer höheren, zu praktisch vollständiger Imidisierung führenden Temperatur ausgehärtet wird. Anstatt die Polyamidsäurelösung durch Extrudieren auf die Folie aufzubringen, kann sie auch durch Aufrakeln aufgebracht werden. Eine anschließende Temperaturbehandlung führt zur Entfernung des Lösungsmittels und zur Bildung des Polyimids. Eine Polyimidschicht z.B. auch von mehr als 10 µm Dicke zu erhalten, die keine Unterbrechungen oder Fehler aufgrund von Blasen enthält, die hervorgerufen sind durch Zusammenwirken eines Hauteffektes und einer zu raschen Verdampfung des Lösungsmittels oder des bei der Imidisierung oder Aushärtung entstehenden Wasserdampfes und die fest an dem Substrat haftet, gelingt durch eine besondere Folge von Hitzebehandlungen.

Die bei dem Verfahren verwendeten, durch Umsetzung einer aromatischen Tetracarbonsäure oder ihres Dianhydrids mit einem primären aromatischen Diamin in einem polaren organischen Lösungsmittel erhaltenen Polyamidsäurevorprodukte

besitzen folgende Strukturformel:

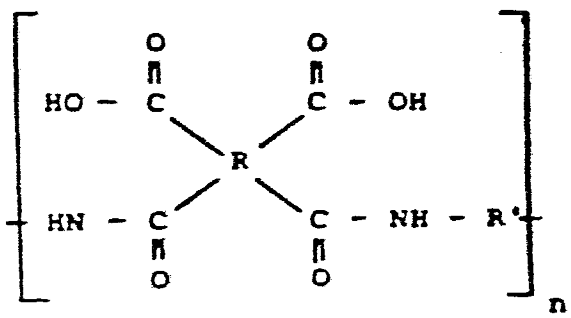

wobei

R einen aromatischen vierwertigen Rest und

R' einen zweiwertigen aromatischen Rest darstellen und

n ausreicht zur Bildung einer Polyamidsäure mit einer reduzierten Viskosität von 0,5 oder höher, gemessen als 0,5%ige Lösung in 0,1 Mol/Liter Lithiumbromid enthaltendem Dimethylacetamid. Die Polyamidsäure wird nach dem Aufbringen auf das Substrat nach dem offenbarten Erhitzungsverfahren ausgehärtet, wobei ein nicht mehr formbares, in Phenol bzw. phenolartigen Lösungsmitteln unlösliches Polyimid mit der folgenden sich wiederholenden Struktur entsteht:

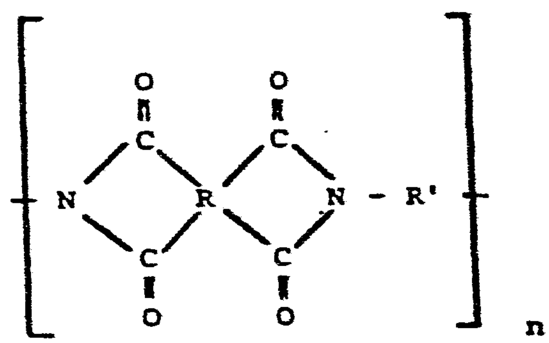

in der R und R' gleiche Reste darstellen, wie sie zuvor beschrieben worden sind.

Bei der Herstellung der Polyamidsäure werden als Ausgangsmaterialien vorzugsweise Pyromellitsäuredianhydrid und 4,4'-Diaminodiphenyläther und als Lösungsmittel vorzugsweise Dimethylacetamid verwendet.

Nach dem Verfahren können zur Herstellung der single clads, d.h. der mit Polyimid beschichteten Folie, auch andere Reaktionspartner extrudiert werden, die in herkömmlichen phenolischen Lösungsmitteln, z.B. Phenol oder substituierten Phenolen (halogenierten Phenolen), unlösliche, nicht mehr formbare Polyimide bilden.

Obwohl als Lösungsmittel vorzugsweise Dimethylacetamid (DMAc) verwendet wird, können auch andere polare organische Lösungsmittel, zum Beippiel N,N-Dimethyl-methoxyacetamid, Dimethylformamid (DMF); Diäthylformamid: N-Methyl-2-Pyrrolidon (NMP) und Dimethylsulfoxyd (DMSO) eingesetzt werden. Als weitere Lösungsmittel können zum Beispiel N-Methylcaprolactam, Dimethylsulfon, Pyridin, Hexamethylphosphoramid, N-Acetyl-2-Pyrrolidon, Tetramethylharnstoff und Tetramethylensulfon verwendet werden.

Die Herstellung der Polyamidsäure kann gemäß dem Stand der Technik, wie er beispielsweise in den US-Patentschriften 3 179 614 und 3 179 634 beschrieben ist, erfolgen.

In der Abbildung 1 wird eine geeignete Vorrichtung zur Durchführung des hier beschriebenen Verfahrensschrittes schematisch dargestellt. Abbildung 2 stellt den Querschnitt des Kondensations- bzw. Aushärtungsofens entlang der Linie 2-2 dar.

In der in Abb. 1 dargestellten Vorrichtung wird z.B. aus dem Dianhydrid und dem Diamin eine trockene Mischung mit einem Molverhältnis: Pyromellitsäuredianhydrid (PMDA): 4,4'-Diaminodiphenyläther (DADE) zwischen 0,95 : 1 und 1,05 : 1 hergestellt. Diese Mischung wird einer gravimetrischen Dosiervorrichtung 3 zugeführt. Dann wird die Mischung mit genau gesteuerter Geschwindigkeit in ein Extruder-Reaktionsgefäß 4 eingespeist. Mit Hilfe einer Dosierpumpe 5 wird der in dem Extruderreaktionsgefäß 4 befindlichen trockenen Mischung ein polares Lösungsmittel zugesetzt. Das Molekulargewicht der Polyamidsäure wird durch das Molverhältnis von Dianhydrid zu Diamin bestimmt. Den optimalen Molekulargewichtsbereich der Polyamidsäure erreicht man bei einem Molverhältnis zwischen 0,98 und 1,02 und er wird als reduzierte Viskosität ($\eta_{red}$) einer 0,5%igen Lösung in 0,1 Mol/liter Lithiumbromid enthaltendem Dimethylacetamid gemessen. Die reduzierte Viskosität der Polyamidsäure beträgt bei molaren Verhältnissen von 0,95 und 1,05 PMDA : DADE etwa 0,5 und liegt beim optimalen Verhältnis (zwischen 0,98 bis 1,02 PMDA : DADE) zwischen ca. 1,0 und 4,0. Bei einem molaren Verhältnis von 0,95 wurde ein durchschnittliches Molekulargewicht der gebildeten Polyamidsäure von 32 000 gefunden, bei 1,0 ca. 200 000, bei 1,03 ca. 35 000 (Bestimmung mit einem FIKA-Lichtstreuungsphotometer, Modell PGD 42 000 bei $\lambda$ = 436 nm).

Die Temperatur im Extruderreaktionsgefäß 4 sollte auf einem Niveau unter ca. 80°C gehalten werden; in der Praxis kann sie jedoch allmählich von ca. 20°C ausgehend gesteigert oder in Zonen mit ansteigender Temperatur auf maximal 80°C angehoben werden. Das Lösungsmittel wird in der ersten Zone des Extruderreaktionsgefäßes 4 zugesetzt. Die Verweilzeit im Extruderreaktionsgefäß 4 liegt im Bereich von 1 bis 5 Minuten.

Am Ende dieser Verweilzeit ist die Reaktion zur Bildung der Polyamidsäure abgeschlossen. Die Polyamidsäure mit einer reduzierten Viskosität von 0,5 bis 4,0, vorzugsweise mehr als 1,0 kann dann durch eine Schlitzdüse 6 auf die Folie extrudiert werden.

Die mit der Polyamidsäurelösung beschichtete Folie läuft dann 5 bis 20 Minuten oder länger zwecks Kondensation zum Polyimid durch einen Ofen 10, dem mittels einer Versorgungsleitung 11 Stickstoff zugespeist wird. Die Durchlaufzeit hängt von der Filmdicke ab, da bei erhöhter Dicke längere Zeiten erforderlich sind.

Es hat sich als wesentlich erwiesen, die Temperaturen in aufeinanderfolgenden Zonen im Ofen zu steuern; wenn jedoch diese Steuerung innerhalb des genannten Bereiches erfolgt, bildet sich in sehr kurzer Zeit auf der Folie 7 eine nicht mehr formbare, blasenfreie Polyimidschicht mit ausgezeichneten elektrischen und mechanischen Eigenschaften.
Es ist anzunehmen, daß es erforderlich ist, daß das Lösungsmittel so langsam durch die Polyamidsäureschicht diffundiert und von der freiliegenden Schichtoberfläche freigesetzt wird, daß sich keine Lösungsmittelblasen bilden können, die sich vergrößern und in der Polymerschicht-Matrix eingeschlossen bleiben. Auch muß ein Großteil des Lösungsmittels von der

freiliegenden Seite der Polyamidsäureschicht freigesetzt werden, bevor die Imidisierung abgeschlossen ist. Ferner muß die Imidisierungsreaktion zu 80 bis 90 % bei Temperaturen unter ca. 180 °C abgeschlossen werden, so daß auch der größere Teil des bei der Cyclisierungsreaktion gebildeten Wassers an die Schichtoberfläche diffundiert und freigesetzt wird.

Um das vorstehende Ziel zu erreichen, sind im der Kondensation dienenden Ofen mittels Widerstandselementen 12, 13, 14 und 15 folgende Heizzonen vorgesehen:
In der ersten Zone wird die Temperatur mit einem elektrischen Widerstandselement 12 im Bereich von 100 bis 150 °C gehalten; in der zweiten Zone wird die Temperatur auf ca. 130 °C bis ca. 200 °C, vorzugsweise unterhalb 180 °C angehoben; in der dritten Zone wird die Temperatur auf ca. 200 bis 400 °C erhöht, nachdem im wesentlichen das gesamte Lösungsmittel zur Oberfläche diffundiert und entfernt und auch der größte Teil des bei der Cyclisierungsreaktion gebildeten Wassers entfernt ist; in der vierten Zone wird die Temperatur nochmals, vorzugsweise auf ca. 300 bis 600°C, angehoben. Jede dieser Zonen ist ungefähr gleich lang und daher ist auch die Verweilzeit in den einzelnen Zonen ungefähr gleich. Man kann jedoch die Geschwindigkeit des Durchlaufs und somit den Durchsatz erhöhen, indem man die erste und/oder zweite Zone verlängert oder der ersten Zone eine zusätzliche Heizzone vorschaltet, die man bei einer Temperatur von über 50 °C, jedoch unter der Temperatur der ersten Zone, hält. Bei der in Abbildung 2 gezeigten Vorrichtung kann der Ofen 10 mit beweglichem Deckel 16 versehen sein, um einen leichten Zugang zum Schichtkörper im Ofen zu schaffen.

Nach dem beschriebenen Verfahren wird eine Schicht aus nicht mehr formbarem vollaromatischem, in phenolischen Lösungsmitteln unlöslichen Polyimid erhalten, die an einer Folie haftet.
Nach Abätzen der Metallfolie erhält man eine Polyimidschicht, die ein Bestandteil der Deckschicht der erfindungsgemäßen Schaltelemente ist.

Der zweite Bestandteil dieser Deckschicht ist ein heißsiegelbarer Hochtemperaturklebstoff, der mit der Polyimidschicht direkt verbunden ist.

Unter heißsiegelbaren Hochtemperaturklebstoffen sind solche Produkte zu verstehen, welche bei einer Temperatur im Bereich von 140 bis 500°C formbar sind, ggf. unter Anwendung von Druck, und dabei eine verklebende Wirkung aufweisen. Sie dürfen ferner nicht unterhalb von 200°C schmelzen. Es ist jedoch nicht erforderlich, daß die als Hochtemperaturklebstoffe verwendeten Produkte überhaupt einen definierten Schmelzpunkt oder -bereich aufweisen. Es genügt, wenn sie, ohne zu schmelzen, einer Formgebung im angegebenen Temperaturbereich zugänglich sind. Die Hochtemperaturklebstoffe müssen, wie erwähnt, eine verklebende Wirkung aufweisen. Darunter ist zu verstehen, daß ein Laminat aus Polyimid und Klebstoff, das wie nachfolgend beschrieben hergestellt ist, eine Schälfestigkeit, gemessen nach der in IPC TM 650, 2.4.9 angegebenen Methode, von mindestens 2,0 N/cm aufweisen muß. Das für diesen Test verwendete Laminat wird folgendermaßen hergestellt: Ein single clad aus Metall und Polyimid wird nach dem oben angegebenen Verfahren hergestellt. Auf die Polyimidschicht dieses single clads wird der zu testende

Klebstoff in Form einer Lösung oder als Folie aufgetragen und im ersteren Fall das Lösungsmittel durch Erhitzen entfernt. Anschließend wird bei einer Temperatur im Bereich zwischen 140 und 500°C heißversiegelt, ggf. unter Anwendung von Druck. Die geeigneten Temperatur- und Druckbedingungen hängen von der Art des Klebstoffs ab und lassen sich durch einfache Versuche ermitteln. Nach Entfernen der Metallschicht, z.B. durch Abätzen, kann die Schälfestigkeit bestimmt werden. Produkte, welche weder aus Lösung noch als Folie aufgebracht für den gesamten oben angegebenen Temperaturbereich auch bei Anwendung von Druck keine Schälfestigkeit von mindestens 2,0 N/cm ergeben, sind als Klebstoffe für die erfindungsgemäßen Schaltelemente ungeeignet.

Die Forderung, daß die Klebstoffe bei einer Temperatur im Bereich von 140 bis 500°C heißsiegelbar, d.h. formbar, sein müssen, bedeutet nicht, daß alle Klebstoffe, die diese Forderung erfüllen, für alle Verwendungszwecke der erfindungsgemäßen Schaltelemente geeignet sind. Vielmehr kann es erforderlich sein, daß für einen bestimmten Verwendungszweck nur Klebstoffe verwendet werden, die erst bei 250°C oder höher formbar sind.

Es ist vorteilhaft, wenn in den erfindungsgemäßen Schaltelementen der Schichtverbund aus Polyimid und Klebstoff eine Schälfestigkeit von mehr als 4,0 N/cm aufweist.

In einer bevorzugten Ausführungsform der Erfindung ist der heißsiegelbare Hochtemperaturklebstoff ein heißsiegelbares Polyimid. Die heißsiegelbaren Polyimide weisen gute elektrische und mechanische Eigenschaften auf.

Besonders bevorzugte Beispiele für heißsiegelbare Polyimide sind solche, die durch Umsetzung von Benzophenontetracarbonsäuredianhydrid (BTDA) oder einem Gemisch dieses Dianhydrids und Pyromellithsäuredianhydrid mit 4,4'-Diaminodiphenyläther, 3,3'-Diaminodiphenyläther, 3,3'-Diaminodiphenylsulfon, 3,3'-Diaminodiphenylmethan, 4,4'-Diaminodiphenylsulfon (DDS), 4,4'-Diaminodiphenylmethan (DDM) oder Benzidin oder mit Gemischen dieser Diamine erhalten werden. Es können hierbei Gemische eingesetzt werden, die zwei oder mehr der genannten Diamine enthalten. Das Benzophenontetracarbonsäuredianhydrid kann das 2,3, 2',3'- oder das 3,4, 3', 4'- oder das 2,3, 3',4'-Isomere oder ein Gemisch aus diesen Isomeren sein. Daneben haben sich heißsiegelbare Polyimide als gut geeignet erwiesen, die dadurch gekennzeichnet sind, daß das heißsiegelbare Polyimid das Reaktionsprodukt eines Dianhydrids mit einem Diamin ist, wobei das Dianhydrid die Formel

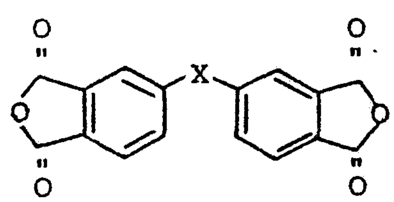

aufweist, worin X für ein Sauerstoffatom steht oder für eine $C_nF_{2n}$-Gruppe mit n = 1 bis 10 oder für die Gruppierung

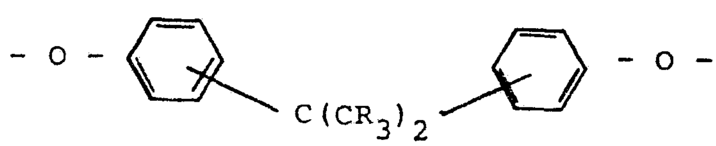

steht, in der R ein Wasserstoffatom oder ein Fluoratom bedeutet und in der die $(CR_3)_2$-Gruppe sich jeweils in meta- oder para-Stellung zum betreffenden Sauerstoffatom befindet und wobei das Diamin die Formel

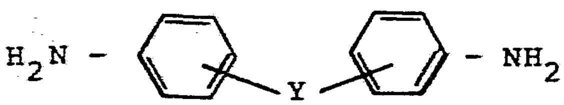

oder die Formel

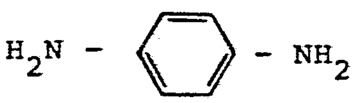

aufweist, wobei Y für ein Sauerstoffatom steht oder für eine $C_nF_{2n}$ -Gruppe mit n = 1 bis 10 oder für eine Carbonylgruppe und wobei sich Y jeweils in meta- oder para-Stellung zur betreffenden Aminogruppe befindet. Die $C_nF_{2n}$-Gruppe kann ein linearer oder verzweigter perfluorierter Alkylrest sein.
Beispiele für weitere geeignete Dianhydride, die mit Diaminen zu heißsiegelbaren Polyimiden umgesetzt werden können, sind Verbindungen der o.a. Formel

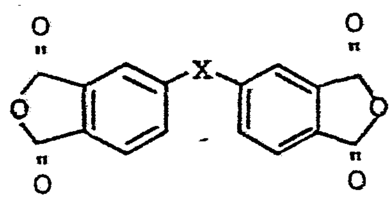

in denen X für

- S - , 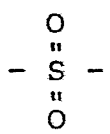 , $C_nH_{2n}$ ,

$C_nH_{2n-2}$ , $C_nF_{2n-2}$ , 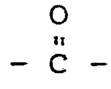 , 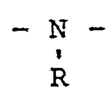 ,

$$-\overset{\overset{O}{\parallel}}{\underset{\underset{R}{|}}{P}}- \quad \text{oder} \quad -O\left(\overset{\overset{CH_3}{|}}{\underset{\underset{CH_3}{|}}{Si}}-O\right)_n \quad \text{steht,}$$

wobei n die Werte 1 bis 10 annehmen kann und R einen linearen oder verzweigten Alkylrest, einen linearen oder verzweigten, ganz oder teilweise halogenierten Alkylrest, einen aromatischen oder heteroaromatischen Rest bedeutet.

Weitere Beispiele für geeignete Diamine, aus denen sich durch Umsetzung mit Dianhydriden heißsiegelbare Polyimide erhalten lassen, sind Diamine der allgemeinen Formel

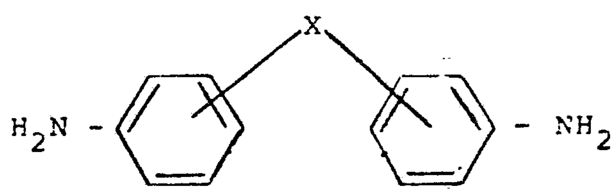

in denen X für die gleichen Gruppen steht wie oben angegeben.
Bei den genannten Diaminen können sich an einem oder beiden aromatischen Ringen ggf. einer oder mehrere weitere Substituenten befinden.
Diese heißsiegelbaren Polyimide können natürlich auch aus anderen Ausgangsverbindungen hergestellt werden, z.B. durch Umsetzung der Tetracarbonsäuren, die diesen Dianhydriden zugrunde liegen, mit den genannten Diaminen.
Eine Reihe dieser bekannten heißsiegelbaren Polyimide sind z.B. in der DE-PS 24 16 595, der DE-PS 24 41 101, der US-PS 3 264 250, in "Chemistry and Industry (12.7. 1969, S. 934) genannt.

Das Erfordernis der Heißsiegelbarkeit bzw. Formbarkeit der Polyimide ist nicht ausschließlich eine Frage der chemischen Natur der Ausgangsverbindungen, also des Dianhydrids und des Diamins. Vielmehr spielen auch die Herstellungsbedingungen, wie z.B. Temperatur oder Molverhältnis der Reaktionspartner, eine Rolle. Mit anderen Worten, es kann von der Wahl der Herstellungsbedingungen abhängen, ob aus den gleichen Ausgangsverbindungen entweder ein nicht mehr formbares oder ein formbares und damit heißsiegelbares Polyimid entsteht.

Eine weitere Ausführungsform der erfindungsgemäßen Schaltelemente ist dadurch gekennzeichnet, daß der heißsiegelbare Hochtemperaturklebstoff ein Hochtemperaturklebstoff ist, der aus der Klasse der Acrylate, Epoxiharze, Fluorpolymerharze, Polysulfonharze, Silikonharze oder Butylkautschuke ausgewählt ist.
Die äußeren Leiterbahnschichten der erfindungsgemäßen Schaltelemente bestehen bevorzugt aus Kupfer, Nickel, Aluminium, Silber, Gold, Edelstahl oder Titan oder einer Legierung, welche eines oder mehrere dieser Metalle als wesentlichen Bestandteil enthält.

Ausgehend von den single clads aus nicht mehr formbarem Polyimid und Metallfolie, deren Herstellung oben beschrieben wurde, kann man nach folgendem Verfahren die erfindungsgemäßen Schaltelemente erhalten:
Man bringt auf die freiliegende Seite der Polyimidschicht eine Schicht aus heißsiegelbarem Hochtemperaturklebstoff auf, entweder in Form einer Lösung oder als Folie. Das Verbinden der Polyimid- mit der Klebstoffschicht erfolgt bei einer Temperatur, bei welcher der Klebstoff formbar,

d.h. siegelbar ist, ggf. unter Anwendung von Druck. In manchen Fällen ist es vorteilhaft, wenn der Klebstoff schon während der Herstellung des single clads, also vor vollständiger Aushärtung des nicht mehr formbaren Polyimids, aufgebracht wird, um nach dem Aushärtungsprozeß eine erhöhte Haftung zwischen Polyimid und Klebstoff zu erzielen.

Vor dem Verbinden der Schicht aus Hochtemperaturklebstoff mit den Leiterbahnschichten des Schaltelements wird die Metallfolie, die mit dem nicht mehr formbaren Polyimid verbunden ist, entfernt. Dies kann z.B. durch Abätzen mit wäßriger Peroxodischwefelsäure geschehen. Das Abätzen der Metallfolie kann vor oder nach dem Verbinden des nicht mehr formbaren Polyimids mit dem Klebstoff geschehen.

Die Deckschicht aus Polyimid und Klebstoff wird nunmehr auf die äußeren Leiterbahnschichten bzw. auf die darauf angeordneten elektrischen Bauelemente aufgebracht. Dies erfolgt wiederum durch Heißversiegeln der Klebstoffschicht mit den Leiterbahnschichten bzw. Bauelementen bei einer Temperatur, bei welcher der Klebstoff formbar ist und ggf. unter Anwendung von Unter- oder Überdruck. Ggf. kann das Versiegeln des Klebstoffs mit der Schicht aus nicht mehr formbarem Polyimid (von der vorher die Metallfolie abgeätzt worden ist) und mit den Leiterbahnschichten in ein und demselben Arbeitsgang erfolgen.

Die erfindungsgemäßen Schaltelemente weisen folgende Vorteile auf:

a) sie besitzen hohe thermische Stabilität und sind damit für Schaltkreise geeignet, die extremen Temperaturbedingungen ausgesetzt werden, wie sie z.B. bei der Anwendung in der Luft- und Raumfahrt, im Bergbau, in der Schiffahrt, in hochwertigen Elektromotoren, in der Steuerung von Triebwerken und in der Computertechnologie auftreten

b) sie weisen geringe Werte für den dielektrischen Verlust auf und sind somit auch bei höchsten Frequenzen im MHz-Bereich und höher einsetzbar.

Die erfindungsgemäßen Schaltelemente können auch hochintegrierte Bauteilgruppen unmittelbar und ohne eigenes Gehäuse enthalten, die ohne Notwendigkeit des Einlötens auf der Leiterbahnseite mit Hilfe von Masken aufgebracht und mit der Deckschicht abgeschlossen werden. Dadurch werden die hohe Packungsdichte der IC (integrierte Schaltung)-Technik und die hohe Packungsdichte der gedruckten Schaltungen miteinander kombiniert.

Patentansprüche

1. Gedrucktes Schaltelement aus einer oder mehreren metallischen Leiterbahnschichten und damit fest verbundenen Isolierschichten, wobei auf einer oder auf beiden der äußeren Leiterbahnschichten bzw. den darauf angeordneten elektrischen Bauelementen eine Deckschicht angebracht ist, dadurch gekennzeichnet, daß die Deckschicht aus einem Schichtverbund aus einem nicht mehr formbaren, vollaromatischen, in phenolischen Lösungsmitteln unlöslichen Polyimid und einem direkt damit verbundenen heißsiegelbaren Hochtemperaturklebstoff besteht, wobei die nicht mit dem vollaromatischen Polyimid verbundene Oberfläche des Hochtemperaturklebstoffs mit der äußeren Leiterbahnschicht bzw. den darauf angeordneten elektrischen Bauelementen verbunden ist.

2. Schaltelement nach Anspruch 1, dadurch gekennzeichnet, daß der Hochtemperaturklebstoff ein heißsiegelbares Polyimid ist.

3. Schaltelement nach Anspruch 2, dadurch gekennzeichnet, daß das heißsiegelbare Polyimid das Reaktionsprodukt von Benzophenontetracarbonsäuredianhydrid (BTDA) oder von einem Gemisch aus BTDA und Pyromellithsäuredianhydrid mit 4,4'-Diaminodiphenyläther, 3,3'-Diaminodiphenyläther, 3,3'-Diaminodiphenylsulfon, 3,3'-Diaminodiphenylmethan, 4,4'-Diaminodiphenylsulfon, 4,4'-Diaminodiphenylmethan oder Benzidin oder mit Gemischen dieser Diamine ist.

4. Schaltelement nach Anspruch 2, dadurch gekennzeichnet, daß das heißsiegelbare Polyimid das Reaktionsprodukt eines Dianhydrids mit einem Diamin ist, wobei das Dianhydrid die Formel

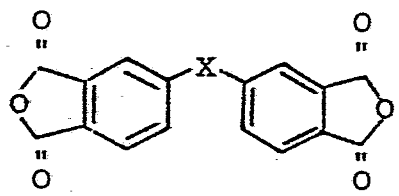

aufweist, worin X für ein Sauerstoffatom steht oder für eine $C_nF_{2n}$ -Gruppe mit n = 1 bis 10 oder für die Gruppierung

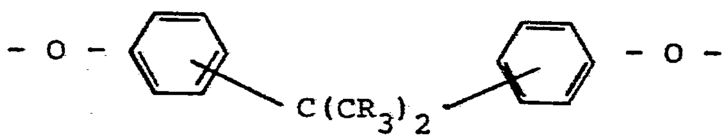

steht, in der R ein Wasserstoffatom oder ein Fluoratom bedeutet und in der die $(CR_3)_2$-Gruppe sich jeweils in meta- oder para-Stellung zum betreffenden Sauerstoffatom befindet und wobei das Diamin die Formel

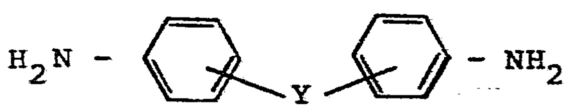

oder die Formel

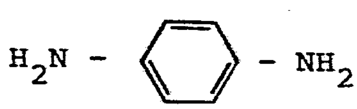

aufweist, wobei Y für ein Sauerstoffatom steht oder

für eine $C_nF_{2n}$ -Gruppe mit n = 1 bis 10 oder für eine Carbonylgruppe und wobei sich Y jeweils in meta- oder para-Stellung zur betreffenden Aminogruppe befindet.

5. Schaltelement nach Anspruch 1, dadurch gekennzeichnet, daß der heißsiegelbare Hochtemperaturklebstoff ein Hochtemperaturklebstoff ist, der aus der Klasse der Acrylate, Epoxiharze, Fluorpolymerharze, Polysulfonharze, Silikonharze oder Butylkautschuke ausgewählt ist.

6. Schaltelement nach den Ansprüchen 1 bis 5, dadurch gekennzeichnet, daß die äußeren Leiterbahnen aus Kupfer, Nickel, Aluminium, Silber, Gold, Edelstahl oder Titan oder einer Legierung, welche eines oder mehrere dieser Metalle als wesentlichen Bestandteil enthält, bestehen.

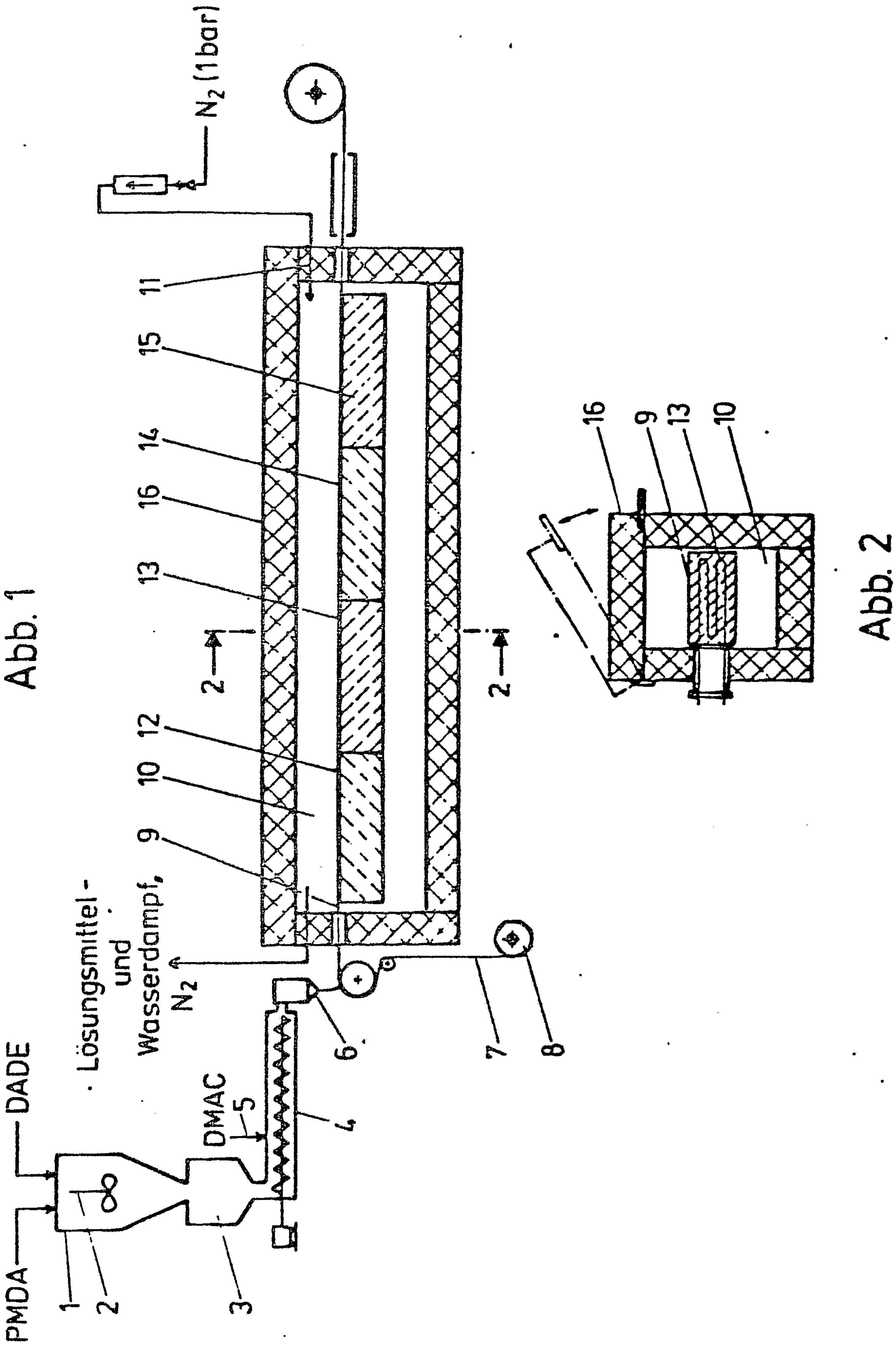
PMDA
DADE
1
2
3
4
5
DMAC
6
7
8
Lösungsmittel - und Wasserdampf, $N_2$
9
10
11
12
13
14
15
16
2
$N_2$ (1bar)
16
9
13
10

Abb. 1

Abb. 2